# FASCICULE DE BREVET EUROPEEN

(11) **EP 3 321 975 B1**
(45) Date de publication et mention de la délivrance du brevet: **28.08.2019**
(21) Numéro de dépôt: 17200974.8
(22) Date de dépôt: 10.11.2017
(51) Int. Cl.: H01L 31/048

(54) **MODULE PHOTOVOLTAÏQUE COMPORTANT UNE COUCHE D'ADHÉSION ENTRE UNE COUCHE DE PROTECTION ET UN ENSEMBLE ENCAPSULANT**
FOTOVOLTAIKMODUL, DAS EINE HAFTSCHICHT ZWISCHEN EINER SCHUTZSCHICHT UND EINER EINKAPSELUNGSEINHEIT UMFASST
PHOTOVOLTAIC MODULE INCLUDING AN ADHESION LAYER BETWEEN A PROTECTIVE LAYER AND AN ENCAPSULATING ASSEMBLY

(30) Priorité: 14.11.2016 FR 1660990
(43) Date de publication de la demande: 16.05.2018
(73) Titulaire: Commissariat à l'énergie atomique et aux énergies alternatives, 75015 Paris (FR)
(72) Inventeur: BOULANGER, Amandine, 73420 VIVIERS DU LAC (FR); GERRITSEN, Eric, 38190 BERNIN (FR); LEFILLASTRE, Paul, 75013 PARIS (FR); SICOT, Lionel, 73000 Chambéry (FR)
(74) Mandataire: Brevalex

(56) Documents cités:
- WO-A1-2013/125874
- WO-A2-2008/022342
- US-A1- 2003 029 493
- US-A1- 2007 295 390
- US-A1- 2012 048 349
- US-B1- 6 369 316

## Description

### DOMAINE TECHNIQUE

La présente invention se rapporte au domaine des modules photovoltaïques, qui comportent un ensemble de cellules photovoltaïques reliées entre elles électriquement, et préférentiellement des cellules photovoltaïques dites « cristallines », c'est-à-dire qui sont à base de silicium monocristallin ou multicristallin. Plus particulièrement, l'invention concerne l'adhésion réalisée entre une couche de protection d'un module photovoltaïque et un ensemble encapsulant du module photovoltaïque.

L'invention peut être mise en oeuvre pour de nombreuses applications, comme par exemple pour des applications qui requièrent l'utilisation de modules photovoltaïques légers, en particulier d'un poids par unité de surface inférieur ou égal à 7 kg/m², notamment inférieur ou égal à 6 kg/m², voire 5 kg/m², et présentant des propriétés de résistance mécanique respectant les normes IEC 61215 et IEC 61730.

L'invention peut ainsi être appliquée par exemple pour des bâtiments tels que des habitats ou locaux industriels (tertiaires, commerciaux, ...), par exemple pour la réalisation de leurs toitures, pour la conception de mobilier urbain, par exemple pour de l'éclairage public, la signalisation routière ou encore la recharge de voitures électriques, voire également être utilisée pour des applications nomades, en particulier pour une intégration sur des voitures, bus ou bateaux, entre autres.

L'invention propose ainsi un module photovoltaïque comportant une couche d'adhésion entre une couche de protection et un ensemble encapsulant du module, ainsi qu'un procédé de réalisation d'un tel module photovoltaïque.

### ÉTAT DE LA TECHNIQUE ANTÉRIEURE

Un module photovoltaïque est un assemblage de cellules photovoltaïques disposées côte à côte entre une première couche transparente formant une face avant du module photovoltaïque et une seconde couche formant une face arrière du module photovoltaïque.

La première couche formant la face avant du module photovoltaïque est avantageusement transparente pour permettre aux cellules photovoltaïques de recevoir un flux lumineux. Elle est traditionnellement réalisée en une seule plaque de verre, présentant une épaisseur typiquement comprise entre 2 et 4 mm, classiquement de l'ordre de 3 mm.

La deuxième couche formant la face arrière du module photovoltaïque peut quant à elle être réalisée à base de verre, de métal ou de plastique, entre autres. Elle est souvent formée par une structure polymérique à base d'un polymère isolant électrique, par exemple du type polytéréphtalate d'éthylène (PET) ou polyamide (PA), pouvant être protégée par une ou des couches à base de polymères fluorés, comme le polyfluorure de vinyle (PVF) ou le polyfluorure de vinylidène (PVDF), et ayant une épaisseur de l'ordre de 400 µm.

Les cellules photovoltaïques peuvent être reliées électriquement entre elles par des éléments de contact électrique avant et arrière, appelés conducteurs de liaison, et formés par exemple par des bandes de cuivre étamé, respectivement disposées contre les faces avant (faces se trouvant en regard de la face avant du module photovoltaïque destinée à recevoir un flux lumineux) et arrière (faces se trouvant en regard de la face arrière du module photovoltaïque) de chacune des cellules photovoltaïques.

Par ailleurs, les cellules photovoltaïques, situées entre les première et deuxième couches formant respectivement les faces avant et arrière du module photovoltaïque, peuvent être encapsulées. De façon classique, l'encapsulant choisi correspond à un polymère du type élastomère (ou caoutchouc), et peut par exemple consister en l'utilisation de deux couches (ou films) de poly(éthylène-acétate de vinyle) (EVA) entre lesquelles sont disposées les cellules photovoltaïques et les conducteurs de liaison des cellules. Chaque couche d'encapsulant peut présenter une épaisseur d'au moins 0,2 mm et un module de Young typiquement compris entre 2 et 400 MPa à température ambiante.

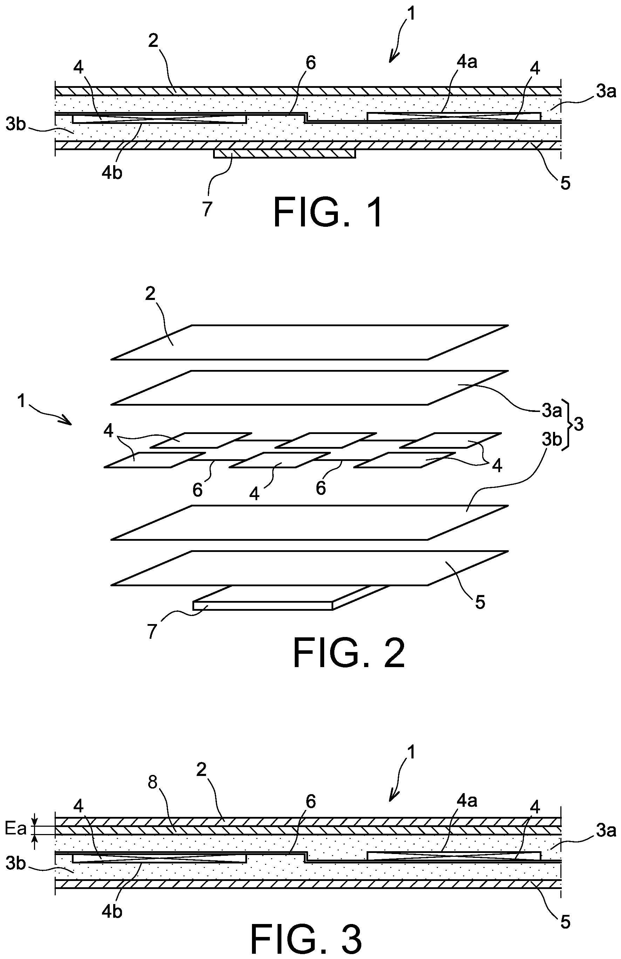

On a ainsi représenté partiellement et schématiquement, respectivement en coupe sur la figure 1 et en vue éclatée sur la figure 2, un exemple classique de module photovoltaïque 1 comportant des cellules photovoltaïques 4 cristallines.

Comme décrit précédemment, le module photovoltaïque 1 comporte une face avant 2, généralement réalisée en verre trempé transparent d'épaisseur d'environ 3 mm, et une face arrière 5, par exemple constituée par une feuille polymère, opaque ou transparente, monocouche ou multicouche, ayant un module de Young supérieur à 400 MPa à température ambiante.

Entre les faces avant 2 et arrière 5 du module photovoltaïque 1 se situent les cellules photovoltaïques 4, reliées électriquement entre elles par des conducteurs de liaison 6 et immergées entre deux couches avant 3a et arrière 3b de matériau d'encapsulation formant toutes les deux un ensemble encapsulant 3.

Par ailleurs, les figures 1 et 2 représentent également la boîte de jonction 7 du module photovoltaïque 1, destinée à recevoir le câblage nécessaire à l'exploitation du module. Classiquement, cette boîte de jonction 7 est réalisée en plastique ou en caoutchouc, et présente une étanchéité complète.

De façon habituelle, le procédé de réalisation du module photovoltaïque 1 comporte une étape dite de lamination sous vide des différentes couches décrites précédemment, à une température supérieure ou égale à 120°C, voire 140°C, voire encore 150°C, et inférieure ou égale à 170°C, typiquement comprise entre 145 et 160°C, et pendant une durée du cycle de lamination d'au moins 10 minutes, voire 15 minutes.

Pendant cette étape de lamination, les couches de matériau d'encapsulation 3a et 3b fondent et viennent englober les cellules photovoltaïques 4, en même temps que l'adhérence se crée à toutes les interfaces entre les couches, à savoir entre la face avant 2 et la couche avant de matériau d'encapsulation 3a, la couche de matériau d'encapsulation 3a et les faces avant 4a des cellules photovoltaïques 4, les faces arrière 4b des cellules photovoltaïques 4 et la couche arrière de matériau d'encapsulation 3b, et la couche arrière de matériau d'encapsulation 3b et la face arrière 5 du module photovoltaïque 1. Le module photovoltaïque 1 obtenu est ensuite encadré, typiquement par le biais d'un profilé en aluminium.

Une telle structure est maintenant devenue un standard qui possède une résistance mécanique importante grâce à l'utilisation d'une face avant 2 en verre épais, lui permettant dans la majorité des cas de respecter les normes IEC 61215 et IEC 61730.

Néanmoins, un tel module photovoltaïque 1 selon la conception classique de l'art antérieur présente l'inconvénient d'avoir un poids élevé, en particulier un poids par unité de surface d'environ 12 kg/m², et n'est ainsi pas adapté pour certaines applications pour lesquelles la légèreté est une priorité.

Aussi, afin d'obtenir une réduction significative du poids d'un module photovoltaïque pour permettre son utilisation dans de nouvelles applications exigeantes en termes de légèreté, il est connu de remplacer le verre en face avant du module par des matériaux polymères plus légers et plus minces. On peut ainsi citer à ce titre la demande de brevet FR 2 955 051 A1, la demande de brevet américain US 2005/0178428 A1 ou encore les demandes internationales WO 2008/019229 A2 et WO 2012/140585 A1. Dans la demande internationale WO2013125874 A1, un module de cellules solaires comprenant une feuille arrière est décrit, dans lequel la feuille arrière comprend: une couche en pellicule de polyester; et des couches en pellicule de polyéthylène, qui sont formées sur les deux surfaces de la couche en pellicule de polyester et qui contiennent un matériau inorganique blanc constitué par exemple de particules de dioxyde de titane.

Les modules photovoltaïques obtenus possèdent un poids surfacique très inférieur à celui des modules photovoltaïques classiquement réalisés avec du verre épais en face avant.

Cependant, pour pouvoir utiliser un matériau polymère en face avant du module photovoltaïque, en alternative à l'utilisation du verre, il faut encore pouvoir assurer une force d'adhésion suffisante entre le matériau polymère et l'ensemble encapsulant du module.

Or, de nombreux matériaux utilisés pour réaliser l'ensemble encapsulant d'un module photovoltaïque, tels que par exemple le poly(éthylène-acétate de vinyle) (EVA), les ionomères, les polyuréthanes thermoplastiques (TPU), les élastomères de silicone, entre autres, n'adhèrent pas suffisamment à des surfaces en polymère, comme notamment le polyméthacrylate de méthyle (PMMA), si bien qu'ils sont parfois remplacés par d'autres matériaux moins performants et/ou plus coûteux.

Pour améliorer la force d'adhésion entre l'ensemble encapsulant et le matériau polymère de la face avant du module, il peut être possible d'effectuer un traitement de type corona mais celui-ci n'est pas toujours efficace et s'avère être instable dans le temps, étant effectué juste avant l'étape de lamination.

### EXPOSÉ DE L'INVENTION

Il existe ainsi un besoin pour permettre une amélioration de l'adhésion entre une première couche formant la face avant du module, réalisée en matériau polymère, et un ensemble encapsulant du module.

L'invention a pour but de remédier au moins partiellement aux besoins mentionnés précédemment et aux inconvénients relatifs aux réalisations de l'art antérieur.

L'invention a ainsi pour objet, selon l'un de ses aspects, un module photovoltaïque comportant :
- une couche de protection du module photovoltaïque,
- une pluralité de cellules photovoltaïques, notamment des cellules photovoltaïques à base de silicium telles que des cellules photovoltaïques à homojonction ou à hétérojonction, disposées côte à côte et reliées électriquement entre elles,
- un ensemble encapsulant la pluralité de cellules photovoltaïques, caractérisé en ce qu'il comporte en outre au moins une couche d'adhésion située entre la couche de protection et l'ensemble encapsulant, ladite au moins une couche d'adhésion comportant majoritairement de l'alumine (Al₂O₃) ou majoritairement du dioxyde titane (TiO₂), et est en contact direct avec la couche de protection et avec l'ensemble encapsulant.

Par le terme « encapsulant » ou « encapsulé », il faut comprendre que la pluralité de cellules photovoltaïques est disposée dans un volume, par exemple hermétiquement clos vis-à-vis des liquides, au moins en partie formé par au moins une couche de matériau d'encapsulation.

En effet, initialement, c'est-à-dire avant toute opération de lamination, l'ensemble encapsulant est constitué par au moins une couche de matériau d'encapsulation, dans laquelle la pluralité de cellules photovoltaïques est encapsulée. En général, l'ensemble encapsulant est formé d'au moins deux couches de matériau d'encapsulation entre lesquelles la pluralité des cellules photovoltaïques est encapsulée. Pendant l'opération de lamination des couches, les couches de matériau d'encapsulation sont fondues afin d'encaspuler les cellules photovoltaïques après l'opération de lamination. On parle alors d'ensemble d'encapsulant dans lequel sont noyées les cellules photovoltaïques.

Par ailleurs, par « couche d'adhésion », on entend une couche permettant à la couche de protection d'adhérer à l'ensemble encapsulant. Il s'agit ainsi d'une couche permettant une compatibilité physico-chimique et une adhésion entre la couche de protection et l'ensemble encapsulant.

Grâce à l'invention, il peut ainsi être possible d'améliorer de façon significative la force d'adhésion entre une couche de protection avant et/ou arrière du module photovoltaïque et son ensemble encapsulant, par exemple d'un facteur 3, mieux d'un facteur 5, mieux encore d'un facteur 10, voire plus.

Le module photovoltaïque selon l'invention peut en outre comporter l'une ou plusieurs des caractéristiques suivantes prises isolément ou suivant toutes combinaisons techniques possibles.

La couche de protection peut être une couche formant la face avant du module photovoltaïque. De façon avantageuse, une telle couche formant la face avant du module photovoltaïque est transparente et destinée à recevoir un flux lumineux.

Le terme « transparent » signifie que le matériau de la couche formant la face avant du module photovoltaïque est au moins partiellement transparent à la lumière visible, laissant passer au moins environ 80 % de cette lumière.

La couche de protection peut encore être une couche formant la face arrière du module photovoltaïque.

Une telle couche formant la face avant ou la face arrière du module photovoltaïque est réalisée en au moins un matériau polymère de la famille des acrylates, et notamment de type polyméthacrylate de méthyle (PMMA).

De façon préférentielle, le module photovoltaïque comporte une première couche de protection formant la face avant du module photovoltaïque, et une deuxième couche de protection formant la face arrière du module photovoltaïque, l'ensemble encapsulant et la pluralité de cellules photovoltaïques étant situés entre les première et deuxième couches de protection.

Dans ce cas, le module photovoltaïque peut comporter au moins une couche d'adhésion située entre l'une des première et deuxième couches de protection et l'ensemble encapsulant, ladite couche d'adhésion comportant de l'alumine (Al₂O₃) ou du dioxyde titane (TiO₂). Ladite au moins une couche d'adhésion peut ainsi être située entre la première couche de protection et l'ensemble encapsulant, et/ou entre la deuxième couche de protection et l'ensemble encapsulant. Ainsi, ladite au moins une couche d'adhésion peut favoriser l'adhésion de la face avant avec l'ensemble encapsulant ou bien l'adhésion de la face arrière avec l'ensemble encapsulant, ou bien encore deux couches d'adhésion peuvent être prévues pour les deux faces avant et arrière.

La première couche de protection peut avantageusement être réalisée en au moins un matériau polymère, préférentiellement en au moins un matériau polymère de la famille des acrylates, et notamment de type polyméthacrylate de méthyle (PMMA).

La deuxième couche de protection peut être réalisée en au moins un matériau polymère, préférentiellement en au moins un matériau polymère de la famille des acrylates, et notamment de type polyméthacrylate de méthyle (PMMA), ou peut comporter un film du type Tedlar®/ polytéréphtalate d'éthylène (PET)/Tedlar® (ou encore TPT). La deuxième couche de protection peut encore comporter un film polymère à base de polyoléfines, notamment un film multicouche coextrudé à base de polypropylène (PP), polyamide (PA) et polyéthylène (PE), par exemple un film de la gamme Reflexolar® commercialisée par la société Renolit. La deuxième couche de protection peut aussi être entièrement réalisée en polytéréphtalate d'éthylène (PET), comme commercialisé par la société COVEME.

Par ailleurs, ladite au moins une couche d'adhésion est en contact direct avec la couche de protection, par exemple la première et/ou la deuxième couches de protection, et avec l'ensemble encapsulant.

En outre, la couche de protection, et par exemple la première couche de protection et/ou la deuxième couche de protection, peut encore être une structure multicouche. Dans ce cas, au moins une couche de cette structure multicouche peut être réalisée en au moins un matériau polymère, préférentiellement en au moins un matériau polymère de la famille des acrylates, et notamment de type polyméthacrylate de méthyle (PMMA). Avantageusement, ladite au moins une couche réalisée en au moins un matériau polymère de cette structure multicouche est en contact direct avec ladite au moins une couche d'adhésion.

Ladite au moins une couche d'adhésion comporte majoritairement, et de préférence uniquement, de l'alumine (Al₂O₃) ou comporte majoritairement, et de préférence uniquement, du dioxyde titane (TiO₂).

Lorsqu'elle comporte majoritairement, et de préférence uniquement, de l'alumine (Al₂O₃), l'épaisseur de ladite au moins une couche d'adhésion peut être comprise entre 10 et 60 nm, étant de préférence comprise entre 15 et 45 nm, de préférence encore comprise entre 20 et 40 nm, et notamment égale à environ 25 nm, voire environ 30 nm.

Par ailleurs, lorsqu'elle comporte majoritairement, et de préférence uniquement, du dioxyde titane (TiO₂), l'épaisseur de ladite au moins une couche d'adhésion peut être comprise entre 5 et 35 nm, de préférence comprise entre 10 et 25 nm, étant notamment égale à environ 15 nm.

De plus, l'ensemble encapsulant peut être réalisé à partir d'au moins un matériau polymère choisi parmi : les copolymères d'acides, les ionomères, le poly(éthylène-acétate de vinyle) (EVA), les acétates de vinyle , tels que les polyvinylbutyrals (PVB), les polyuréthanes, les chlorures de polyvinyle, les polyéthylènes, tels que les polyéthylènes linéaires basse densité, les polyoléfines thermoplastiques (TPO), les polyoléfines élastomères de copolymères, les copolymères d'a-oléfines et des α-, β- esters d'acide carboxylique à éthylénique, tels que les copolymères éthylène-acrylate de méthyle et les copolymères éthylène-acrylate de butyle, les élastomères de silicone et/ou les résines époxy, entre autres.

De préférence, l'ensemble encapsulant peut être réalisé à partir d'au moins une couche de poly(éthylène-acétate de vinyle) (EVA), notamment au moins deux couches de poly(éthylène-acétate de vinyle) (EVA) entre lesquelles sont disposées les cellules photovoltaïques.

Les cellules photovoltaïques peuvent être choisies parmi : des cellules photovoltaïques homojonction ou hétérojonction à base de silicium monocristallin (c-Si) et/ou multi-cristallin (mc-Si), et/ou des cellules photovoltaïques comprenant au moins un matériau parmi le silicium amorphe (a-Si), le silicium microcristallin (µC-Si), le tellurure de cadmium (CdTe), le cuivre-indium séléniure (CIS) et le cuivre-indium/gallium diséléniure (CIGS), entre autres.

Par ailleurs, les cellules photovoltaïques peuvent présenter une épaisseur comprise entre 1 et 300 µm.

Par ailleurs, quand bien même la première couche de protection formant la face avant du module photovoltaïque est transparente, la deuxième couche de protection formant la face arrière du module photovoltaïque peut être ou non transparente, étant notamment opaque.

En outre, l'espacement entre deux cellules photovoltaïques voisines, ou encore consécutives ou adjacentes, peut être supérieur ou égal à 1 mm, notamment compris entre 1 et 30 mm, et de préférence égal à 3 mm.

De plus, l'invention a encore pour objet, selon un autre de ses aspects, un procédé de réalisation d'un module photovoltaïque tel que défini précédemment, caractérisé en ce qu'il comporte l'étape d'application d'au moins une couche d'adhésion, comportant de l'alumine (Al₂O₃) ou du dioxyde titane (TiO₂), entre la couche de protection et l'ensemble encapsulant du module photovoltaïque.

Le procédé peut en outre comporter l'étape d'application d'au moins une couche d'adhésion sur les bords latéraux, ou encore les tranches, de la couche de protection. Cette application peut se faire sur les bords latéraux de la première couche de protection formant la face avant et/ou de la deuxième de protection formant la face arrière du module photovoltaïque. Cette application peut par exemple servir à favoriser l'adhésion d'un autre revêtement sur les bords latéraux de la couche de protection, notamment de la première couche de protection et/ou de la deuxième couche de protection.

Le procédé peut par ailleurs comporter l'étape d'application de ladite au moins une couche d'adhésion entre la couche de protection et l'ensemble encapsulant du module photovoltaïque, sur au moins une partie de la couche de protection avant une étape de lamination de ladite couche de protection pourvue de ladite au moins une couche d'adhésion avec l'ensemble encapsulant comprenant les cellules photovoltaïques.

La couche de protection peut correspondre la première couche de protection formant la face avant et/ou la deuxième couche de protection formant la face arrière du module photovoltaïque. Ladite au moins une partie de la couche de protection sur laquelle est appliquée ladite au moins une couche d'adhésion correspond avantageusement à la zone destinée à entrer en contact avec l'ensemble encapsulant.

Ladite au moins une couche d'adhésion peut être appliquée par un procédé de dépôt de couches minces atomiques (ou encore ALD pour « Atomic Layer Déposition » en anglais).

Le dépôt de couches minces atomiques (ALD) peut notamment être réalisé à une température comprise entre 50 et 150°C, notamment environ égale à 90°C.

Le module photovoltaïque et le procédé de réalisation selon l'invention peuvent comporter l'une quelconque des caractéristiques précédemment énoncées, prises isolément ou selon toutes combinaisons techniquement possibles avec d'autres caractéristiques.

### BRÈVE DESCRIPTION DES DESSINS

L'invention pourra être mieux comprise à la lecture de la description détaillée qui va suivre, d'exemples de mise en oeuvre non limitatifs de celle-ci, ainsi qu'à l'examen des figures, schématiques et partielles, du dessin annexé, sur lequel :
- la figure 1 représente, en coupe, un exemple classique de module photovoltaïque comportant des cellules photovoltaïques cristallines,
- la figure 2 représente, en vue éclatée, le module photovoltaïque de la figure 1,
- la figure 3 représente, en coupe, un exemple de module photovoltaïque conforme à l'invention,

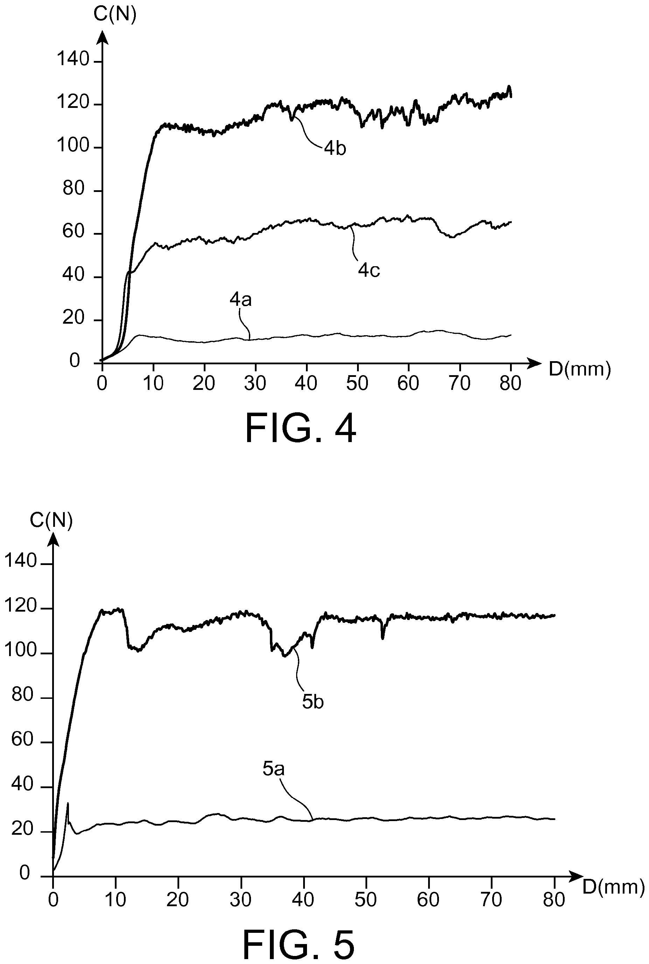

- la figure 4 illustre, sous forme graphique, l'évolution de la charge, exprimée en N, en fonction du déplacement de pelage, exprimé en mm, pour un module photovoltaïque comprenant une première couche en PMMA nanostructuré et un ensemble encapsulant en EVA, pour trois cas : un cas selon l'art antérieur de référence avec effet corona du PMMA, un cas selon l'invention de dépôt d'une couche d'adhésion de Al₂O₃ sur le PMMA avec une épaisseur de 25 nm et un cas selon l'invention de dépôt d'une couche d'adhésion de Al₂O₃ sur le PMMA avec une épaisseur de 60 nm,
- la figure 5 illustre, sous forme graphique, l'évolution de la charge, exprimée en N, en fonction du déplacement de pelage, exprimé en mm, pour un module photovoltaïque comprenant une première couche en PMMA et un ensemble encapsulant en EVA, pour deux cas : un cas selon l'art antérieur de référence sans dépôt sur le PMMA et un cas selon l'invention de dépôt d'une couche d'adhésion de Al₂O₃ sur le PMMA avec une épaisseur de 25 nm,

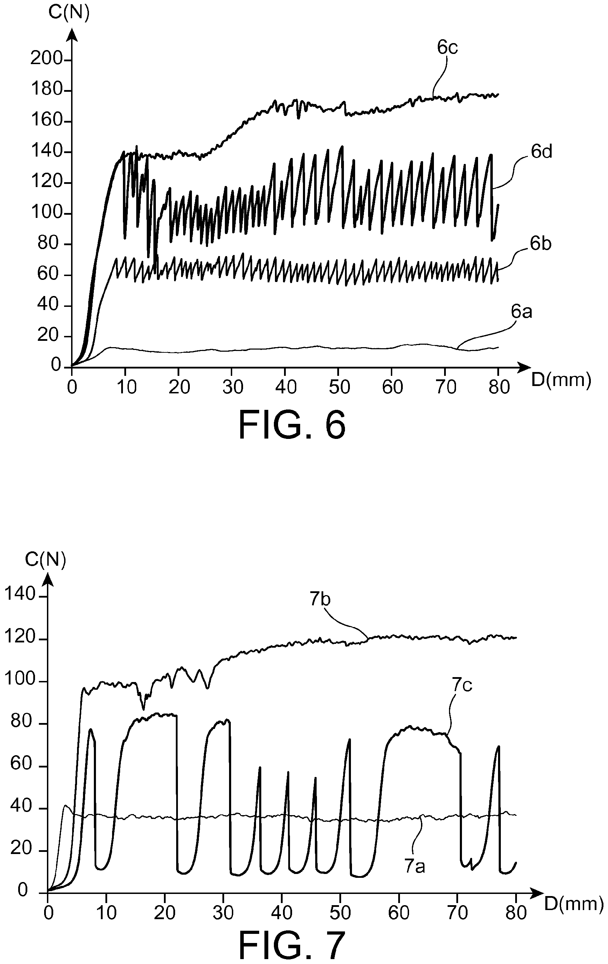

- la figure 6 illustre, sous forme graphique, l'évolution de la charge, exprimée en N, en fonction du déplacement de pelage, exprimé en mm, pour un module photovoltaïque comprenant une première couche en PMMA nanostructuré et un ensemble encapsulant en EVA, pour trois cas : un cas selon l'art antérieur de référence avec effet corona du PMMA, un cas selon l'invention de dépôt d'une couche d'adhésion de TiO₂ sur le PMMA avec une épaisseur de 5 nm, un cas selon l'invention de dépôt d'une couche d'adhésion de TiO₂ sur le PMMA avec une épaisseur de 15 nm et un cas selon l'invention de dépôt d'une couche d'adhésion de TiO₂ sur le PMMA avec une épaisseur de 25 nm,
- la figure 7 illustre, sous forme graphique, l'évolution de la charge, exprimée en N, en fonction du déplacement de pelage, exprimé en mm, pour un module photovoltaïque comprenant une première couche en PMMA nanostructuré et un ensemble encapsulant en polyuréthane thermoplastique (TPU), pour trois cas : un cas selon l'art antérieur de référence avec effet corona du PMMA, un cas selon l'invention de dépôt d'une couche d'adhésion de Al₂O₃ sur le PMMA avec une épaisseur de 25 nm et un cas selon l'invention de dépôt d'une couche d'adhésion de Al₂O₃ sur le PMMA avec une épaisseur de 60 nm, et

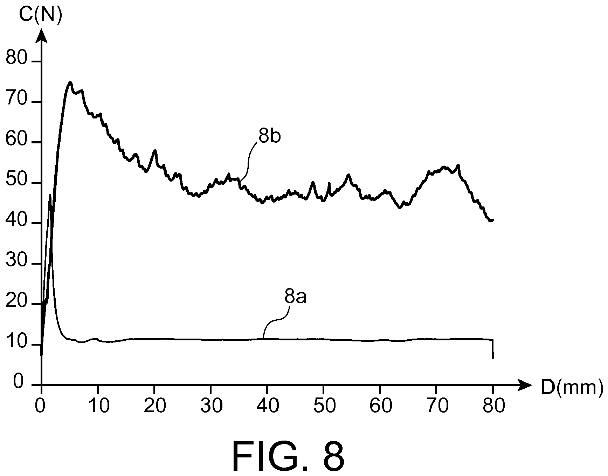

- la figure 8 illustre, sous forme graphique, l'évolution de la charge, exprimée en N, en fonction du déplacement de pelage, exprimé en mm, pour un module photovoltaïque comprenant une première couche en PMMA et un ensemble encapsulant en polyuréthane thermoplastique (TPU), pour deux cas : un cas selon l'art antérieur de référence sans dépôt sur le PMMA et un cas selon l'invention de dépôt d'une couche d'adhésion de Al₂O₃ sur le PMMA avec une épaisseur de 25 nm.

Dans l'ensemble de ces figures, des références identiques peuvent désigner des éléments identiques ou analogues.

De plus, les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

Les figures 1 et 2 ont déjà été décrites dans la partie relative à l'état de la technique antérieure.

La figure 3 représente, en coupe, un exemple de module photovoltaïque 1 conforme à l'invention.

Comme décrit précédemment en référence à la figure 1, le module photovoltaïque 1 comporte une première couche 2 transparente formant la face avant du module photovoltaïque 1, destinée à recevoir un flux lumineux.

Cette première couche 2 est avantageusement réalisée en au moins un matériau polymère de la famille des acrylates, et plus particulièrement de type polyméthacrylate de méthyle (PMMA).

De plus, le module photovoltaïque 1 comporte une pluralité de cellules photovoltaïques 4, par exemple des cellules photovoltaïques à base de silicium telles que des cellules à homojonction ou à hétérojonction, disposées côte à côte et reliées électriquement entre elles, ainsi qu'un ensemble encapsulant 3 la pluralité de cellules photovoltaïques 4, et enfin une deuxième couche 5 formant la face arrière du module photovoltaïque 1.

L'ensemble encapsulant 3 et la pluralité de cellules photovoltaïques 4 sont situés entre les première 2 et deuxième 5 couches.

Conformément à l'invention, le module photovoltaïque 1 comporte en outre une couche d'adhésion 8 située entre la première couche 2 et l'ensemble encapsulant 3, cette couche d'adhésion 8 comportant de l'alumine Al₂O₃ ou du dioxyde titane TiO₂, comme il sera expliqué par la suite.

Les figures 4 à 8 permettent de décrire, à l'aide de résultats présentés sous forme graphique, divers exemples de réalisation conformes à l'invention.

En particulier, deux types d'ensemble encapsulant ont été utilisés, à savoir l'EVA ou le TPU, et deux types de PMMA ont également été utilisés, à savoir du PMMA classique ou du PMMA nanostructuré. De plus, des couches d'adhésion comprenant soit de l'alumine, soit du dioxyde de titane, ont été utilisées, avec des épaisseurs variables. Pour la deuxième couche formant la face arrière du module, un film du type Tedlar®/ polytéréphtalate d'éthylène (PET)/Tedlar® (ou encore TPT) a été utilisé.

A chaque fois, la couche d'adhésion a été appliquée par dépôt de couches minces atomiques, ou encore appelé procédé ALD, à une température de 90°C.

Au préalable, il est à noter que la force moyenne d'adhésion de l'EVA sur le PMMA est de 0,2 N/mm, sachant qu'après traitement corona, cette force peut être améliorée de 1 N/mm.

L'adhésion entre le PMMA et l'ensemble encapsulant, de type EVA ou TPU, a été évaluée par un test de pelage sur un banc de type INSTRON, le test étant effectué à un angle de 180 degrés.

La figure 4 illustre, sous forme graphique, l'évolution de la charge C, exprimée en N, en fonction du déplacement de pelage D, exprimé en mm, pour un module photovoltaïque comprenant une première couche en PMMA nanostructuré et un ensemble encapsulant en EVA, pour trois cas : un cas 4a selon l'art antérieur de référence avec effet corona du PMMA, un cas 4b selon l'invention de dépôt d'une couche d'adhésion de Al₂O₃ sur le PMMA avec une épaisseur Ea de 25 nm et un cas 4c selon l'invention de dépôt d'une couche d'adhésion de Al₂O₃ sur le PMMA avec une épaisseur Ea de 60 nm.

On constate ainsi que le dépôt par ALD de la couche d'adhésion d'alumine Al₂O₃ avec une épaisseur de 25 nm (cas 4b) permet de multiplier par 10 la force d'adhésion de l'EVA avec le PMMA nanostructuré.

La figure 5 illustre, sous forme graphique, l'évolution de la charge C, exprimée en N, en fonction du déplacement de pelage D, exprimé en mm, pour un module photovoltaïque comprenant une première couche en PMMA classique et un ensemble encapsulant en EVA, pour deux cas : un cas 5a selon l'art antérieur de référence sans dépôt sur le PMMA et un cas 5b selon l'invention de dépôt d'une couche d'adhésion de Al₂O₃ sur le PMMA avec une épaisseur Ea de 25 nm.

On constate ainsi que le dépôt par ALD de la couche d'adhésion d'alumine Al₂O₃ avec une épaisseur de 25 nm (cas 5b) permet de multiplier par 5 la force d'adhésion de l'EVA avec le PMMA classique.

La figure 6 illustre, sous forme graphique, l'évolution de la charge C, exprimée en N, en fonction du déplacement de pelage D, exprimé en mm, pour un module photovoltaïque comprenant une première couche en PMMA nanostructuré et un ensemble encapsulant en EVA, pour trois cas : un cas 6a selon l'art antérieur de référence avec effet corona du PMMA, un cas 6b selon l'invention de dépôt d'une couche d'adhésion de TiO₂ sur le PMMA avec une épaisseur Ea de 5 nm, un cas 6c selon l'invention de dépôt d'une couche d'adhésion de TiO₂ sur le PMMA avec une épaisseur Ea de 15 nm et un cas 6d selon l'invention de dépôt d'une couche d'adhésion de TiO₂ sur le PMMA avec une épaisseur Ea de 25 nm.

On constate ainsi que le dépôt par ALD de la couche d'adhésion de dioxyde de titane TiO₂ permet d'augmenter la force d'adhésion de l'EVA avec le PMMA classique, avec une valeur optimale (14 N/mm) obtenue pour une épaisseur de 15 nm (cas 6c).

La figure 7 illustre, sous forme graphique, l'évolution de la charge C, exprimée en N, en fonction du déplacement de pelage D, exprimé en mm, pour un module photovoltaïque comprenant une première couche en PMMA nanostructuré et un ensemble encapsulant en polyuréthane thermoplastique (TPU), pour trois cas : un cas 7a selon l'art antérieur de référence avec effet corona du PMMA, un cas 7b selon l'invention de dépôt d'une couche d'adhésion de Al₂O₃ sur le PMMA avec une épaisseur Ea de 25 nm et un cas 7c selon l'invention de dépôt d'une couche d'adhésion de Al₂O₃ sur le PMMA avec une épaisseur Ea de 60 nm.

On constate ainsi que le dépôt par ALD de la couche d'adhésion d'alumine Al₂O₃ avec une épaisseur de 25 nm (cas 7b) permet de multiplier par 3 la force d'adhésion du TPU avec le PMMA nanostructuré.

Enfin, la figure 8 illustre, sous forme graphique, l'évolution de la charge C, exprimée en N, en fonction du déplacement de pelage D, exprimé en mm, pour un module photovoltaïque comprenant une première couche en PMMA classique et un ensemble encapsulant en polyuréthane thermoplastique (TPU), pour deux cas : un cas 8a selon l'art antérieur de référence sans dépôt sur le PMMA et un cas 8b selon l'invention de dépôt d'une couche d'adhésion de Al₂O₃ sur le PMMA avec une épaisseur Ea de 25 nm.

On constate ainsi que le dépôt par ALD de la couche d'adhésion d'alumine Al₂O₃ avec une épaisseur de 25 nm (cas 8b) permet de multiplier par 5 la force d'adhésion du TPU avec le PMMA.

Bien entendu, l'invention n'est pas limitée aux exemples de réalisation qui viennent d'être décrits. Diverses modifications peuvent y être apportées par l'homme du métier.

## Revendications

1. Module photovoltaïque (1) comportant :
- une couche de protection (2) du module photovoltaïque (1),
- une pluralité de cellules photovoltaïques (4) disposées côte à côte et reliées électriquement entre elles,
- un ensemble encapsulant (3) la pluralité de cellules photovoltaïques (4),
**caractérisé en ce qu'**il comporte en outre au moins une couche d'adhésion (8) située entre la couche de protection (2) et l'ensemble encapsulant (3), ladite au moins une couche d'adhésion (8) comportant majoritairement de l'alumine (Al₂O₃) ou majoritairement du dioxyde titane (TiO₂),
**en ce que** la couche de protection (2) est réalisée en au moins un matériau polymère de la famille des acrylates,
et **en ce que** ladite au moins une couche d'adhésion (8) est en contact direct avec la couche de protection (2) et avec l'ensemble encapsulant (3).

2. Module selon la revendication 1, **caractérisé en ce que** ladite au moins une couche d'adhésion (8) comporte uniquement de l'alumine (Al₂O₃) ou uniquement du dioxyde titane (TiO₂).

3. Module selon la revendication 1 ou 2, **caractérisé en ce que** les cellules photovoltaïques (4) sont des cellules photovoltaïques à base de silicium, notamment des cellules photovoltaïques à homojonction ou à hétérojonction.

4. Module selon l'une des revendications précédentes, **caractérisé en ce que** la couche de protection (2) est réalisée en au moins un matériau polymère de type polyméthacrylate de méthyle (PMMA).

5. Module selon l'une quelconque des revendications précédentes, **caractérisé en ce qu'**il comporte :
- une première couche de protection (2) du module photovoltaïque (1) formant la face avant du module photovoltaïque (1), transparente et destinée à recevoir un flux lumineux,
- une deuxième couche de protection (5) du module photovoltaïque (1) formant la face arrière du module photovoltaïque (1),
l'ensemble encapsulant (3) et la pluralité de cellules photovoltaïques (4) étant situés entre les première (2) et deuxième (5) couches de protection, ladite au moins une couche d'adhésion (8) étant située entre l'une des première (2) et deuxième (5) couches de protection et l'ensemble encapsulant (3).

6. Module selon l'une quelconque des revendications précédentes, **caractérisé en ce que**, ladite au moins une couche d'adhésion (8) comportant majoritairement de l'alumine (Al₂O₃), l'épaisseur (Ea) de ladite au moins une couche d'adhésion (8) est comprise entre 10 et 60 nm, étant de préférence comprise entre 15 et 45 nm, de préférence encore comprise entre 20 et 40 nm, et notamment égale à environ 25 nm, voire environ 30 nm.

7. Module selon l'une quelconque des revendications 1 à 5, **caractérisé en ce que**, ladite au moins une couche d'adhésion (8) comportant majoritairement du dioxyde titane (TiO₂), l'épaisseur (Ea) de ladite au moins une couche d'adhésion (8) est comprise entre 5 et 35 nm, de préférence comprise entre 10 et 25 nm, étant notamment égale à environ 15 nm.

8. Module selon l'une quelconque des revendications précédentes, **caractérisé en ce que** l'ensemble encapsulant (3) est réalisé à partir d'au moins un matériau polymère choisi parmi : les copolymères d'acides, les ionomères, le poly(éthylène-acétate de vinyle) (EVA), les acétates de vinyle , tels que les polyvinylbutyrals (PVB), les polyuréthanes, les chlorures de polyvinyle, les polyéthylènes, tels que les polyéthylènes linéaires basse densité, les polyoléfines thermoplastiques (TPO), les polyoléfines élastomères de copolymères, les copolymères d'a-oléfines et des α-, β- esters d'acide carboxylique à éthylénique, tels que les copolymères éthylène-acrylate de méthyle et les copolymères éthylène-acrylate de butyle, les élastomères de silicone et/ou les résines époxy.

9. Module selon la revendication 8, **caractérisé en ce que** l'ensemble encapsulant (3) est réalisé à partir d'au moins une couche de poly(éthylène-acétate de vinyle) (EVA)).

10. Procédé de réalisation d'un module photovoltaïque (1) selon l'une quelconque des revendications précédentes, **caractérisé en ce qu'**il comporte l'étape d'application d'au moins une couche d'adhésion (8), comportant majoritairement de l'alumine (Al₂O₃) ou majoritairement du dioxyde titane (TiO₂), entre la couche de protection (2) et l'ensemble encapsulant (3) du module photovoltaïque (1).

11. Procédé selon la revendication 10, **caractérisé en ce qu'**il comporte en outre l'étape d'application d'au moins une couche d'adhésion sur les bords latéraux de la couche de protection (2).

12. Procédé selon la revendication 10 ou 11, **caractérisé en ce qu'**il comporte l'étape d'application de ladite au moins une couche d'adhésion (8) entre la couche de protection (2) et l'ensemble encapsulant (3) du module photovoltaïque (1), sur au moins une partie de la couche de protection (2) avant une étape de lamination de ladite couche de protection (2) pourvue de ladite au moins une couche d'adhésion (8) avec l'ensemble encapsulant (3) comprenant les cellules photovoltaïques (4).

13. Procédé selon l'une quelconque des revendications 10 à 12, **caractérisé en ce que** ladite au moins une couche d'adhésion (8) est appliquée par un procédé de dépôt de couches minces atomiques (ALD).

14. Procédé selon la revendication 13, **caractérisé en ce que** le dépôt de couches minces atomiques (ALD) est réalisé à une température comprise entre 50 et 150°C, notamment environ égale à 90°C.

## Patentansprüche

1. Fotovoltaik-Modul (1), umfassend:
- eine Schutzschicht (2) des Fotovoltaik-Moduls (1),
- eine Mehrzahl von Fotovoltaik-Zellen (4), welche Seite an Seite angeordnet und untereinander elektrisch verbunden sind,
- eine die Mehrzahl von Fotovoltaik-Zellen (4) verkapselnde Anordnung (3),
**dadurch gekennzeichnet, dass** es ferner wenigstens eine Haftschicht (8) umfasst, welche zwischen der Schutzschicht (2) und der verkapselnden Anordnung (3) angeordnet ist, wobei die wenigstens eine Haftschicht (8) mehrheitlich Aluminiumoxid (Al₂O₃) oder mehrheitlich Titandioxid (TiO₂) umfasst, und dadurch, dass die Schutzschicht (2) aus wenigstens einem Polymermaterial aus der Familie der Acrylate hergestellt ist,
und dadurch, dass die wenigstens eine Haftschicht (8) in direktem Kontakt mit der Schutzschicht (2) und mit der verkapselnden Anordnung (3) ist.

2. Modul nach Anspruch 1, **dadurch gekennzeichnet, dass** die wenigstens eine Haftschicht (8) ausschließlich Aluminiumoxid (Al₂O₃) oder ausschließlich Titandioxid (TiO₂) umfasst.

3. Modul nach Anspruch 1 oder 2, **dadurch gekennzeichnet, dass** die Fotovoltaik-Zellen (4) Fotovoltaik-Zellen auf Grundlage von Silizium sind, insbesondere Fotovoltaik-Zellen mit Homoübergang oder Heteroübergang.

4. Modul nach einem der vorhergehenden Ansprüche, **dadurch gekennzeichnet, dass** die Schutzschicht (2) aus wenigstens einem Polymermaterial vom Polymethylmethacrylat (PMMA)-Typ ist.

5. Modul nach einem der vorhergehenden Ansprüche, **dadurch gekennzeichnet, dass** es umfasst:
- eine erste Schutzschicht (2) des Fotovoltaik-Moduls (1), welche die vordere Fläche des Fotovoltaik-Moduls (1) bildet, transparent und dazu vorgesehen, einen Lichtstrom empfangen,
- eine zweite Schutzschicht (5) des Fotovoltaik-Moduls (1), welche die hintere Fläche des Fotovoltaik-Moduls (1) bildet,
wobei die verkapselnde Anordnung (3) und die Mehrzahl von Fotovoltaik-Zellen (4) zwischen den ersten (2) und zweiten (5) Schutzschichten angeordnet sind, wobei die wenigstens eine Haftschicht (8) zwischen der einen aus den ersten (2) und zweiten (5) Schutzschichten und der verkapselnden Anordnung (3) angeordnet ist.

6. Modul nach einem der vorhergehenden Ansprüche, **dadurch gekennzeichnet, dass** die wenigstens eine Haftschicht (8) mehrheitlich Aluminiumoxid (Al₂O₃) umfasst, wobei die Dicke (Ea) der wenigstens einen Haftschicht (8) zwischen 10 und 60 nm beträgt, vorzugsweise zwischen 15 und 45 nm beträgt, weiter vorzugsweise zwischen 20 und 40 nm beträgt, insbesondere gleich etwa 25 nm oder etwa 30 nm.

7. Modul nach einem der Ansprüche 1 bis 5, **dadurch gekennzeichnet, dass** die wenigstens eine Haftschicht (8) mehrheitlich Titandioxid (TiO₂) umfasst, wobei die Dicke (Ea) der wenigstens einen Haftschicht (8) zwischen 5 und 35 nm beträgt, vorzugsweise zwischen 10 und 25 nm beträgt, insbesondere gleich etwa 15 nm.

8. Modul nach einem der vorhergehenden Ansprüche, **dadurch gekennzeichnet, dass** die verkapselnde Anordnung (3) ausgehend von wenigstens einem Polymermaterial hergestellt ist, ausgewählt aus: Co-Polymere von Säuren, lonomere, Ethylen-Vinylacetat-Polymer (EVA), Vinylacetate, wie beispielsweise Polyvinylbutyrale (PVB), Polyurethane, Polyvinylchloride, Polyethylene, wie beispielsweise lineare Polyethylene mit niedriger Dichte, thermoplastische Polyolefine (TPO), elastomere Polyolefine von Copolymeren, Copolymere von α-Olefinen und α-,β-Ethylen-Carboxylsäureestern, wie beispielsweise Ethylen-Methylacrylat-Copolymere und Ethylen-Butylacrylat-Copolymere, Silikonelastomere und/oder Epoxidharze.

9. Modul nach Anspruch 8, **dadurch gekennzeichnet, dass** die verkapselnde Anordnung (3) ausgehend von wenigstens einer Schicht aus Ethylen-Vinylacetat-Polymer (EVA) hergestellt ist.

10. Verfahren zum Herstellen eines Fotovoltaik-Moduls (1) nach einem der vorhergehenden Ansprüche, **dadurch gekennzeichnet, dass** es den Schritt eines Aufbringens von wenigstens einer Haftschicht (8), welche insbesondere mehrheitlich Aluminiumoxid (Al₂O₃) oder mehrheitlich Titandioxid (TiO₂) umfasst, zwischen der Schutzschicht (2) und der verkapselnden Anordnung (3) des Fotovoltaik-Moduls (1) umfasst.

11. Verfahren nach Anspruch 10, **dadurch gekennzeichnet, dass** es ferner den Schritt eines Aufbringens von wenigstens einer Haftschicht an den lateralen Rändern der Schutzschicht (2) umfasst.

12. Verfahren nach Anspruch 10 oder 11, **dadurch gekennzeichnet, dass** es den Schritt eines Aufbringens der wenigstens einen Haftschicht (8) zwischen der Schutzschicht (2) und der verkapselnden Anordnung (3) des Fotovoltaik-Moduls (1) an wenigstens einem Teil der Schutzschicht (2) vor einem Schritt eines Laminierens der Schutzschicht (2) umfasst, welcher die wenigstens eine Haftschicht (8) mit der verkapselnden Anordnung (3) versieht, welche die Fotovoltaik-Zellen (4) umfasst.

13. Verfahren nach einem der Ansprüche 10 bis 12, **dadurch gekennzeichnet, dass** die wenigstens eine Haftschicht (8) durch ein Verfahren eines atomaren Dünnschicht-Deponierens (ALD) aufgebracht wird.

14. Verfahren nach Anspruch 13, **dadurch gekennzeichnet, dass** das Deponieren der atomaren Dünnschichten (ALD) bei einer Temperatur durchgeführt wird, welche zwischen 50 und 150°C beträgt, insbesondere etwa gleich 90°C.

## Claims

1. Photovoltaic module (1) comprising:
- a protective layer (2) of the photovoltaic module (1),
- a plurality of photovoltaic cells (4) arranged side-by-side and electrically connected together,
- an assembly encapsulating (3) the plurality of photovoltaic cells (4),
**characterised in that** it further comprises at least one adhesion layer (8) located between the protective layer (2) and the encapsulating assembly (3), said at least one adhesion layer (8) comprising mostly alumina (Al₂O₃) or mostly titanium dioxide (TiO₂),
and **in that** the protective layer (2) is made from at least one polymer material of the acrylate family,
and **in that** said at least one adhesion layer (8) is in direct contact with the protective layer (2) and with the encapsulating assembly (3).

2. Module according to claim 1, **characterised in that** said at least one adhesion layer (8) comprises only alumina (Al₂O₃) or only titanium dioxide (TiO₂) .

3. Module according to claim 1 or 2, **characterised in that** the photovoltaic cells (4) are photovoltaic cells with a silicon base, in particular homojunction or heterojunction photovoltaic cells.

4. Module according to one of the preceding claims, **characterised in that** the protective layer (2) is made from at least one polymer material of the polymethyl methacrylate (PMMA) type.

5. Module according to any one of the preceding claims, **characterised in that** it comprises:
- a first protective layer (2) of the photovoltaic module (1) forming the front face of the photovoltaic module (1), transparent and intended to receive a luminous flux,
- a second protective layer (5) of the photovoltaic module (1) forming the rear face of the photovoltaic module (1),
with the encapsulating assembly (3) and the plurality of photovoltaic cells (4) being located between the first (2) and second (5) protective layers, said at least one adhesion layer (8) being located between one of the first (2) and second (5) protective layers and the encapsulating assembly (3).

6. Module according to any one of the preceding claims, **characterised in that**, said at least one adhesion layer (8) comprising mostly alumina (Al₂O₃), the thickness (Ea) of said at least one adhesion layer (8) is between 10 and 60 nm, being preferably between 15 and 45 nm, more preferably between 20 and 40 nm, and in particular equal to about 25 nm, or about 30 nm.

7. Module according to any of claims 1 to 5, **characterised in that**, said at least one adhesion layer (8) comprising mostly titanium dioxide (TiO₂), the thickness (Ea) of said at least one adhesion layer (8) is between 5 and 35 nm, preferably between 10 and 25 nm, being in particular equal to about 15 nm.

8. Module according to any one of the preceding claims, **characterised in that** the encapsulating assembly (3) is made from at least one polymer material chosen from: copolymers of acids, ionomers, poly(ethylene-vinyl acetate) (EVA), vinyl acetates, such as polyvinylbutyrals (PVB), polyurethanes, polyvinyl chlorides, polyethylenes, such as low density linear polyethylenes, thermoplastic polyolefins (TPO), copolymer elastomeric polyolefins, copolymers of α-olefins and α-, β- esters of ethylene carboxylic acids, such as ethylene-methyl acrylate copolymers and ethylene butyl acrylate copolymers, silicone elastomers and/or epoxy resins.

9. Module according to claim 8, **characterised in that** the encapsulating assembly (3) is made using at least one layer of poly(ethylene-vinyl acetate) (EVA)).

10. Method for producing a photovoltaic module (1) according to any one of the preceding claims, **characterised in that** it comprises the step of applying at least one adhesion layer (8), comprising mostly alumina (Al₂O₃) or mostly titanium dioxide (TiO₂) , between the protective layer (2) and the encapsulating assembly (3) of the photovoltaic module (1).

11. Method according to claim 10, **characterised in that** it further comprises the step of applying at least one adhesion layer on the lateral edges of the protective layer (2).

12. Method according to claim 10 or 11, **characterised in that** it comprises the step of applying said at least one adhesion layer (8) between the protective layer (2) and the encapsulating assembly (3) of the photovoltaic module (1), on at least one portion of the protective layer (2) before a step of rolling said protective layer (2) provided with said at least one adhesion layer (8) with the encapsulating assembly (3) comprising the photovoltaic cells (4).

13. Method according to any of claims 10 to 12, **characterised in that** said at least one adhesion layer (8) is applied by a method of atomic layer deposition (ALD).

14. Method according to claim 13, **characterised in that** the atomic layer depositions (ALD) is carried out at a temperature between 50 and 150°C, in particular about equal to 90°C.
